# EUROPEAN PATENT SPECIFICATION

(11) **EP 0 793 251 B1**
(45) Date of publication and mention of the grant of the patent: **13.06.2001**
(21) Application number: 97300991.3
(22) Date of filing: 14.02.1997
(51) Int. Cl.: H01J 9/385

(54) **Conveyance vehicle for a vacuum vessel**
Transportfahrzeug für einen Vakuumgefäss
Véhicule de transport pour une enceinte à vide

(30) Priority: 27.02.1996 GB 9604069
(43) Date of publication of application: 03.09.1997
(73) Proprietor: The BOC Group plc, Windlesham Surrey GU20 6HJ (GB)
(72) Inventor: Huntley, G., Crawley, West Sussex, RH10 7LG (GB)
(74) Representative: Gough, Peter

(56) References cited:
- EP-A- 0 667 634
- EP-A- 0 743 668
- US-A- 4 071 058

## Description

The present invention relates to improved conveyance systems for use in the processing of evacuated articles and, more particularly to individual vehicles for use in such systems.

In the production of television picture tubes or other forms of similar tubes, it is generally necessary in a final process stage to evacuate the tube to a residual pressure of less than about 10⁻⁶ mbar whilst allowing for the tube to be heated during at least some of the process stages.

In a typical production line, each tube is mounted on to an individual conveyance vehicle (sometimes referred to as a "cart") with a plurality of such vehicles forming part of a conveyance system in which the vehicles are in slow but continuous motion along straight or circular/oval production lines. Each conveyance system can typically comprise up to two hundred and fifty vehicles with a production line time of, for example, seventy to one hundred minutes (or more depending on the article being processed.)

Each vehicle generally incorporates equipment required to carry out the various finishing process stages for the picture tubes. The known vehicles generally possess a vacuum system in the form, for example, of a diffusion pump or turbomolecular pump backed by a rotary pump.

The known vehicles conventionally possess a gripper assembly including a seal for receiving the "neck" of the television tube and sealingly connecting the interior of the tube to the vacuum system for maintaining a vacuum therein.

However, in order to inhibit degradation of the seal during subsequent heating of the television tube it is known to use water cooling to effect cooling of the gripper assembly and in particular the seal.

The use of water cooling with moving vehicles is complicated and gives rise to maintenance problems and low reliability.

In European publication no 0667634 there is disclosed a non-water cooled conveyance vehicle for the transportation of a vessel to be evacuated. The vehicle includes a vacuum pumping system and a gripper assembly for receiving a neck of the vessel. The gripper assembly includes a seal for sealingly connecting the interior of the vessel to the vacuum pumping system. Further, an on-board refrigeration system is provided for circulating refrigerant fluid to and from heat exchange means associated with the gripper assembly.

It is an aim of the present invention to provide a conveyance vehicle for the transportation of a vessel to be evacuated in which a heat pipe is used to inhibit degradation of the seal when subjected to elevated temperatures.

According to the present invention a conveyance vehicle for the transportation of a vessel to be evacuated comprises:
a) a vacuum pumping system;
b) a gripper assembly for receiving an initially open neck of the vessel;
c) the gripper assembly including a seal for sealingly connecting the interior of the vessel to the vacuum pumping system via the neck; and is characterised in that
d) at least one heat pipe is provided located adjacent the seal for inhibiting degradation of the seal when subjected to elevated temperatures.

Preferably, the heat pipe is thermally connected at one end to the gripper assembly and at its opposite end to cooling fins.

An embodiment of the invention will now be described, by way of example, reference being made to the Figures of the accompanying diagrammatic drawings in which:-
Figure 1 is a perspective view of a conveyance vehicle;
Figure 2 is an end elevation of the conveyance vehicle of Figure 1 shown carrying two television tubes;
Figure 3 is a cross-section through a known gripper assembly;
Figure 4 is a detail in cross-section of a gripper assembly and a heat sink according to the present invention; and
Figure 5 is a view on the line A-A of Figure 4.

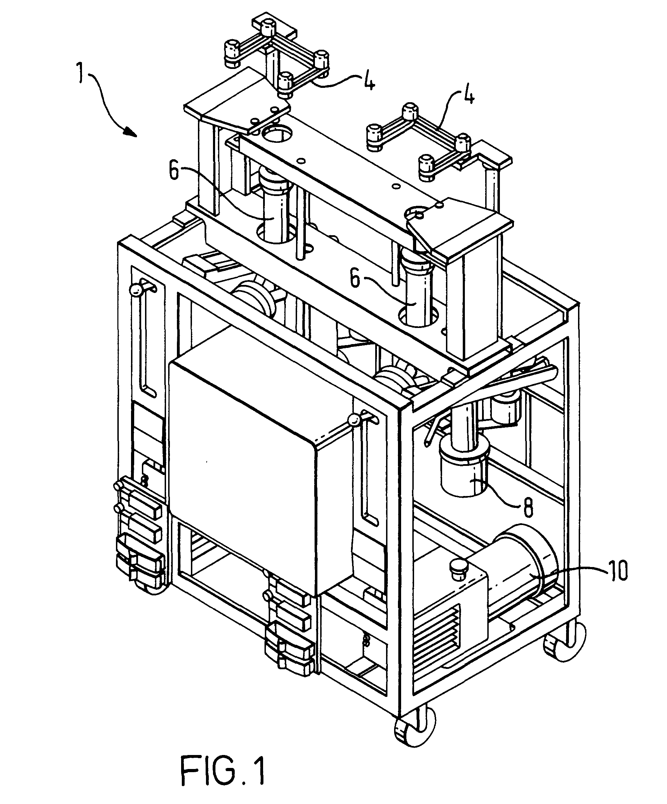

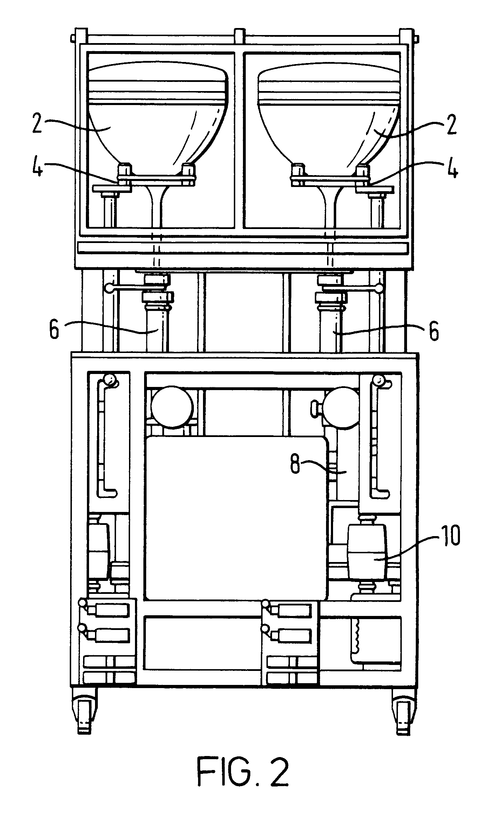

Referring first to Figures 1 and 2, there is shown a conveyance vehicle or 'cart' 1 for the transportation of television tubes 2. Each television tube 2 is mounted on a tube support 4 and the initially open neck is received within the open (upper as shown) end of a gripper assembly 6. Each gripper assembly 6 communicates with a vacuum pumping system including a diffusion pump 8 and an associated backing pump 10 in the form of an oil-sealed rotary pump.

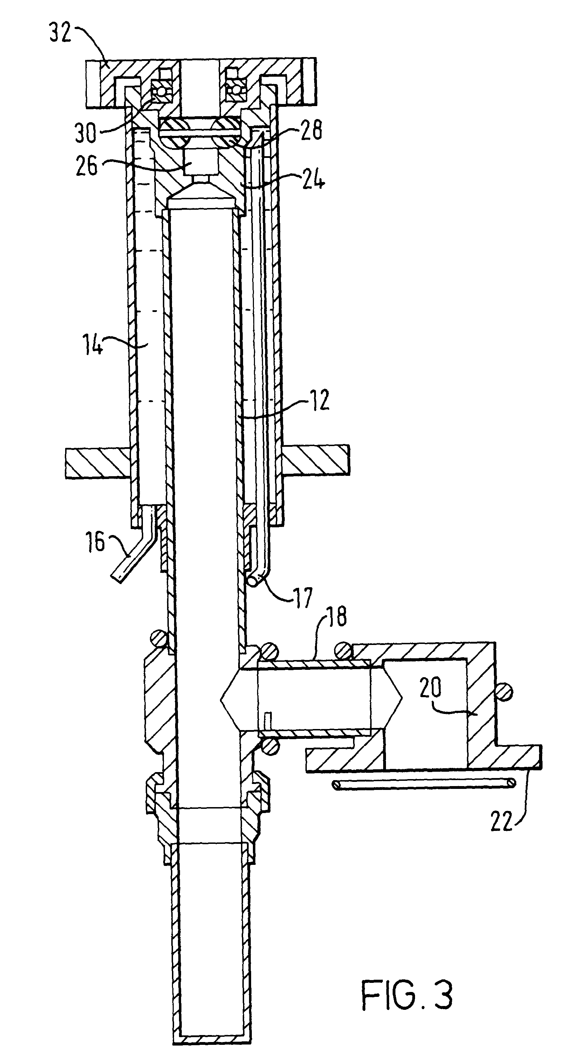

Turning now to Figure 3 which illustrates a conventional gripper assembly, the main components of which are a main tubular part 12 surrounded by a water jacket 14 including a cooling water inlet 16 and a cooling water outlet 17; and a tubular extension 18 connected to a support head 20.

The support head 20 includes a flange 22 to which the diffusion pump 8 is attached.

The main tubular part 12 is terminated at its upper (as shown) end by an end-piece 24 of good thermal conducting material which includes a through passage 26 and a counterbore for receiving an o-ring seal 28. Mounted on the end-piece 24 is a ball bearing assembly 30 and a clamp nut 32.

The end-piece 24 and clamp nut 32 are designed to receive the initially open neck of a television tube 2 and the seal 28, sealingly engages the neck to ensure vacuum tight communication between the interior of the television tube 2 and the vacuum pumping system including the diffusion pump 8.

When in use, water is circulated through the water jacket 14 to ensure the seal 28 does not become degraded through contact with the neck of the television tube 2 when said tube 2 is being heated.

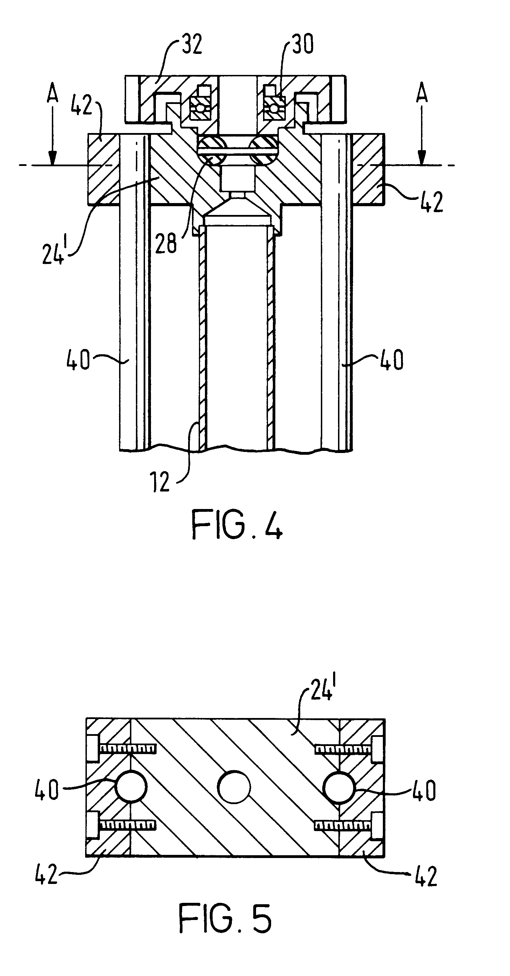

According to the present invention the known gripper assembly illustrated in Figure 3 is modified as illustrated in Figures 4 and 5. The cooling water jacket 14 is discarded and replaced by a heat sink in the form of two heat pipes 40. As shown, each heat pipe 40 at its upper (as shown) end is clamped and thermally connected to the end-piece 24' by means of a side member 42. Each heat pipe 40 is a pressure vessel which exhibits a thermal conductivity some 1000 times better than that of copper. The bottom (not shown) end of each heat pipe 40 is thermally attached to cooling fins which can be aligned with the fins of an air cooled diffusion pump.

The use of the heat pipes 40 to conduct heat away from the gripper assembly 6 and in particular the o-ring seal 28 obviates the need for a relatively complicated water cooled system.

## Claims

1. A conveyance vehicle (1) for the transportation of a vessel (2) to be evacuated, the vehicle comprising:
a) a vacuum pumping system (8,10);
b) a gripper assembly for receiving an initially open neck of the vessel (2);
c) the gripper assembly includes a seal (28) for sealingly connecting the interior of the vessel (2) to the vacuum pumping system via the neck; and
characterised in that
d) at least one heat pipe (40) is provided, located adjacent the seal (28) to inhibit degradation of the seal when subjected to elevated temperatures.

2. A vehicle as claimed in Claim 1, in which the heat pipe (40) has one end thermally connected to the gripper assembly and its opposite end thermally connected to cooling fins.

## Patentansprüche

1. Transportwagen (1) zum Transport eines zu evakuierenden Behälters (2), wobei der Wagen aufweist:
a) ein Vakuumpumpsystem (8, 10),
b) eine Greiferbaugruppe zur Aufnahme eines anfänglich offenen Halses des Behälters (2),
c) wobei die Greiferbaugruppe eine Dichtung (28) zum dichten Verbinden des Inneren des Behälters (2) mit dem Vakuumpumpsystem über den Hals aufweist, und dadurch gekennzeichnet daß
d) mindestens ein Wärmerohr (40) vorgesehen ist, das neben der Dichtung (28) angeordnet ist, um eine Verschlechterung der Dichtung zu verhindern, wenn diese erhöhten Temperaturen ausgesetzt wird.

2. Wagen nach Anspruch 1, wobei das Wärmerohr (40) mit einem Ende thermisch mit der Greiferbaugruppe verbunden und mit seinem entgegengesetzten Ende thermisch mit Kühlrippen verbunden ist.

## Revendications

1. Véhicule (1) de transport pour le transport d'une enceinte (2) dans laquelle le vide doit être fait, le véhicule comprenant :
(a) un système (8, 10) de pompage pour faire le vide ;
(b) un ensemble de serrage destiné à recevoir un goulot, ouvert à l'origine, de l'enceinte (2) ;
(c) l'ensemble de serrage comprend un joint d'étanchéité (28) destiné à raccorder de manière étanche l'intérieur de l'enceinte (2) au système de pompage pour faire le vide, via le goulot ; et
***caractérisé en ce que***
(d) il est prévu au moins un caloduc (40), situé adjacent au joint d'étanchéité (28) pour empêcher la dégradation du joint d'étanchéité lorsqu'il est soumis à des températures élevées.

2. Véhicule selon la Revendication 1, dans lequel le caloduc (40) a l'une de ses extrémités reliée thermiquement à l'ensemble de serrage et son extrémité opposée reliée thermiquement à des ailettes de refroidissement.
